# NEUE EUROPÄISCHE PATENTSCHRIFT

(11) **EP 0 654 819 B2**
(45) Veröffentlichungstag und Bekanntmachung des Hinweises auf die Entscheidung über den Einspruch: **24.11.2004**
(45) Hinweis auf die Patenterteilung: 03.02.1999
(21) Anmeldenummer: 94250278.2
(22) Anmeldetag: 17.11.1994
(51) Int. Cl.: H01L 23/433, H01L 23/467, H01L 23/36

(54) **Verfahren zur Herstellung einer Anordnung zur Wärmeableitung**
Fabrication process for a heat dissipation device
Procédé de fabrication d'un dispositif pour dissiper la chaleur

(30) Priorität: 18.11.1993 DE 4339786
(43) Veröffentlichungstag der Anmeldung: 24.05.1995
(73) Patentinhaber: EMI-TEC, ELEKTRONISCHE MATERIALIEN GmbH, D-12277 Berlin (DE)
(72) Erfinder: Tiburtius, Bernd, Dipl.-Ing., D-14532 Kleinmachnow (DE); Kahl, Helmut, Dipl.-Ing., D-12307 Berlin (DE)
(74) Vertreter: Glawe, Delfs, Moll & Partner

(56) Entgegenhaltungen:
- EP-A- 0 363 687
- EP-A- 0 528 606
- EP-A- 0 629 114
- JP-A- 5 007 177
- US-A- 4 654 754
- US-A- 5 247 426
- IBM TECHNICAL DISCLOSURE BULLETIN, Bd. 21, Nr. 9, Februar 1979 NEW YORK US, Seite 3672 H. PARSAPUR 'Hook and Loop Thermal Conductive Mesh'
- Haus der Technik Fachbuchreihe "Zukunftsorientierte Klebstoffe für Metall- und Nichtmetallverbindungen", Vulkan-Verlag, Essen, 1991, seiten 102-105,120,121,126,127
- RöMPP Chemielexicon, Seite 1196
- Adhaesion, 1998 Heft3 Seiten 10, 13-15, 18, 18
- Neyer H.R.; Wörn H.: 'Entwicklung eines Systems zum automatischen Auftrag Pastöser Klebstoffe', in Handbuch Fertigungstechnologie Kleben, Henneman/Brockmann/Kollek, Carl Hanser Verlag Muenchen Wien (DE/AT), 1992, Seiten 690 bis 701

## Beschreibung

Die Erfindung betrifft ein Verfahren der im Oberbegriff der Ansprüche 1 und 2 angegebenen Art.

In Kunststoff-, Keramik- oder auch Metallgehäuse gekapselte elektronische Bauteile oder Baugruppen, bei deren Betrieb in erheblichem Umfang Verlustwärme entsteht, werden üblicherweise mit Kühlalementen bzw. -körpern versehen, die eine Abfuhr der entstehenden Verlustwärme - vorrangig durch Konvektion und/oder Wärmeleitung - in die Umgebung ermöglichen. Zur Wärmeableitung dienen dabei insbesondere gut wärmeleitfähige - speziell metallische - Träger bzw. Gehäuse(teile), deren Oberfläche bei Bauelementen mit hohem Verlustleistungsanfall möglichst groß gewählt wird. Vielfach sind die entsprechenden Trägerelemente bzw. Gehäuse(teile) zu diesem Zweck verrippt, und/oder ihre Oberfläche wird mit einem von einem Lüfter erzeugten Luftstrom hoher Geschwindigkeit beaufschlagt.

Bekannt ist die Anwendung von Glimmerplättchen oder von Wärmeleitpasten - etwa Silikonpaste mit Aluminumoxid-Beimengung - zu diesem Zweck.

Aus der US 4 654 754 A1 ist eine derartige Anordnung bekannt, bei der wärmeleitende Erhebungen aus elastischem wärmeleitenden Material an eine Wärmequelle angelegt werden und sich dabei verformen.

Diese Anordnung ist umständlich in der Herstellung, da die betreffenden Elemente mittels entsprechender Formen hergestellt werden, welche nur solche Gestaltungen zulassen, die auch entformt werden können. Weiterhin ist die Gestaltung nicht zusammenhängender Gebilde schwierig, da hierfür eine Vielzahl von Einzelformen erzeugt werden müßte. Damit ergibt sich bei der Herstellung der Nachteil einer aufwendigen, den heutigen Erfordernissen der Elektronikindustrie nicht mehr entsprechenden Handhabung und/oder von unbefriedigenden Gebrauchseigenschaften im Betrieb der elektronischen Bauteile bzw. -gruppen (schlechte Wärmeübertragungseigenschaften, Verschmieren auf dem Träger, insbesondere bei großen Temperaturdifferenzen, etc.).

Der Erfindung liegt daher die Aufgabe zugrunde, ein verbessertes Verfahren zur Herstellung einer Wärmeableitanordnung der eingangs genannten Gattung anzugeben.

Diese Aufgabe wird durch ein Verfahren mit den Merkmalen der Ansprüche 1 und 2 gelöst.

Die Erfindung schließt den Gedanken ein, ein Verfahren zur Herstellung einer Anordnung zur Wärmeableitung unter Einschluß des zu kühlenden Bauteils bzw. der Baugruppe anzugeben, bei dem die die Wärmeübertragung an die Umgebung fördernden Mittel auf technologisch fortschrittliche Weise strangweise unmittelbar auf dem zu kühlenden Bauteil bzw. der Baugruppe oder aber einem separaten Kühlkörper erzeugt oder ggf. sogar so ausgebildet wird, daß sie die Funktion des Kühlkörpers mit übernehmen, so daß ein solcher ganz entfallen kann. Auf diese Weise können auch wärmeleitende elastische Gebilde erzeugt werden, die eine pilzartige Kontur (oder deren negatives Abbild) aufweisen und mit herkömmlichen Formmitteln (auch durch Extrudieren) nicht ohne weiteres erzeugt werden könnten. Hierdurch können elektronische Bauelemente beispielsweise ohne weitere Befestigungen durch "Einknöpfen" mit einer Halterung verbunden werden.

Eine günstige Möglichkeit hierfür besteht im Erzeugen eines direkt auf der Oberfläche des elektronischen Bauteils bzw. der Baugruppe gebildeten wärmeleitenden Kunststofformkörpers, der selbst die zur Wärmeabfuhr an die Umgebung benötigte Oberfläche aufweist oder eine wärmeleitende Verbindung mit einem separaten Wärmediffusor herstellt, der nachträglich an der Bauteil-Kunststofformkörper-Einheit befestigt wird.

Eine zweite Möglichkeit besteht im Erzeugen eines von dem Bauteil bzw. der Baugruppe separat gebildeten Wärmediffusors (Kühlkörpers) - als der auch ein ohnehin benötigter Träger oder ein ein oder mehrere Bauelemente oder Baugruppen umschließender Außen-Gehäuse(teil) dienen kann - mit einem direkt auf dessen Oberfläche gebildeten wärmeleitenden Kunststofformkörper, der mindestens im Betrieb des Bauelements bzw. der Baugruppe in Kontakt mit dessen bzw. deren Oberfläche steht. Der Wärmediffusor kann insbesondere durch Verschrauben oder Verpressen fest mit dem Bauteil bzw. der Baugruppe verbunden sein oder an diese(s) lösbar angepreßt werden - etwa durch entsprechendes Bewegen und Arretieren eines beweglichen Gehäuseteils.

Vor allem bei dieser Variante des erfindungsgemäßen Verfahrens ist es für die Gebrauchseigenschaften von Vorteil, wenn der Kunststofformkörper mindestens abschnittsweise elastisch verformbar bzw. kompressibel gebildet wird, so daß durch Vermittlung eines innigen Oberflächenkontakts von Bauteil bzw. -gruppe und Wärmediffusor unter angemessenem Anpreßdruck ein sehr geringer Wärmeübergangswiderstand erreicht und ggf. zugleich eine Abdichtung (etwa eines Außengehäuse-Innenraumes nach außen) bewirkt werden kann. Durch die elastische oder kompressible Ausgestaltung des Formkörpers werden insbesondere Toleranzen zwischen Außengehäuse und Bauelementengehäuse ausgeglichen, so daß eine Gehäusehälfte, in der die zu kühlenden Bauelemente oder Baugruppen vormontiert sind, durch einfaches Verschließen mit der anderen Gehäusehälfte ohne besondere zusätzliche Maßnahmen thermisch kontaktiert werden kann. Diese Handhabung ist insbesondere bei den Baugruppen der Mikroelektronik und miniaturisierten Gehäusen - wie beispielsweise Hand-Funktelefonen von besonderer Bedeutung.

Mit den erfindungsgemäßen Maßnahmen lassen sich größte Bauelemente-Packungsdichten erzeugen, wobei sich für die einzelnen - auch unterschiedlichst geformten - Bauelemente auch auf engstem Raum die notwendigen Kühlmaßnahmen erzeugen lassen, wenn die Kühlkörper durch "Dispensern" aus dem pastösen Zustand heraus aufgebracht werden. Sämtliche Bauelemente werden durch das Verschließen des Gehäuses unabhängig von deren Bauform und eventuell zu überbrückenden Toleranzen gleichmäßig kontaktiert. Fürden Servicefall läßt sich ein derartiges Gehäuse auch jederzeit öffnen. Die Serviceintervalle werden hingegen durch die erfinderischen Maßnahmen vergrößert, da die Lebensdauer elektronischer Halbleiterbauelemente mit abnehmender Betriebstemperatur wesentlich zunimmt. Das kompressible wärmeleitende Kunststoffmaterial wird insbesondere in der Weise aufgetragen, daß im wesentlichen in Richtung der Wärmeübertragung gerichtete Zwischenräume vorgesehen sind, welche bis zu einer maximalen Kompression - im vorgesehenen Toleranzbereich - Material aufnehmen können, wenn das Gehäuse montiert wird. Die Erfindung schließt dabei die Erkenntnis ein, daß die Verbesserung des Wärmekontakts durch die sich anschmiegenden Bereiche des elastischen Kühlkörpers größer ist als die Vergrößerung des Wärmewiderstands infolge des durch die Ausnehmungen verringerten leitenden Querschnitts.

Für eine optimale Wärmeübertragung ist auch eine Abwandlung geeignet, bei der das Bauteil bzw. die Baugruppe und der Wärmediffusor je einen Kunststoffformkörper mit mindestens je einer freien Oberfläche aufweisen und die freien Oberflächen dieser Kunststoffformkörper einander zugewandt sind und mindestens im Betriebszustand des Bauteils oder der Baugruppe in Kontakt miteinander stehen. Durch das Ineinandergreifen von einander versetzt gegenüberliegenden Erhebungen und Vertiefungen der beiden - vorzugsweise elastischen - Kunststofformkörper wird die effektive Kontaktfläche maximiert.

Besonders, wenn sehr große Spalte zwischen Bauelementegehäuse und Außengehäuse zu überbrücken sind, kann es günstig sein, an beiden bei Montage des Bauelements einander kontaktierenden Flächen Kühlkörpergemäß der Erfindung zu bilden, welche sich im endmontierten Zustand gegenseitig flächig berühren und somit für eine gute Wärmeabfuhr sorgen.

Der Kunststofformkörper wird speziell durch Aufdispensern von Kunststoffmaterial im plastifizierten Zustand auf eine Oberfläche des Bauteils bzw. der Baugruppe und Vor-Ort-Aushärten bzw. -Abbinden des Materials gebildet.

Technologisch besonders vorteilhaft ist es, wenn der Kunststofformkörper aus einem bei Raumtemperatur vernetzenden bzw. abbindenden Kunststoff mit wärmeleitender Beimengung besteht, so daß er ohne aufwendige Erwärmung der Anordnung gebildet werden kann. Als wärmeleitende Beimengungen werden beispielsweise elektrisch nichtleitende Metallverbindungen (Bornitrid, Aluminiumoxid) in Pulverform eingesetzt. Weist das Bauteil bzw. die Baugruppe eine elektrisch isolierende Ummantelung auf, kommen auch elektrisch leitende Beimengungen, etwa Metallpulver, in Frage.

Eine einfache und mechanisch stabile Anordnung mit abschnittsweise relativ dickem Kunststofformkörper - wie er etwa bei Nutzung eines beweglichen, mit einer Abdichtung zu versehenden Gehäuseteils als Wärmediffusor erforderlich werden kann - ergibt sich, wenn der Kunststofformkörper mindestens bereichsweise mehrschichtig erzeugt wird, wobei jede Schicht auf der darunterliegenden an Ort und Stelle und mit dieser festhaftend verbunden gebildet wird.

Eine solche Ausbildung ist auch von Vorteil in Verbindung mit einer weiteren Ausbildung, bei der der Kunststofformkörper noppen- oder rippenartige Erhebungen aufweist, die seine Oberfläche und/oder seine Elastizität vergrößern und damit die Wärmeleitungseigesnchaften verbessern. Sie ermöglicht nämlich die Bildung relativ hoher Noppen bzw. Rippen mit hinreichend präzise vorgebbarer Gestalt und ausreichender mechanischer Stabilität.

Wird diese Ausbildung zur Verbesserung der Wärmeableitung bei einem Kunststofformkörper vorgenommen, der selbst als Kühlkörper dient, sind die noppen- oder rippenartigen Erhebungen des Kunststoffformkörpers zweckmäßigerweise der mit ihm verbundenen Oberfläche des Bauteils bzw. der Baugruppe abgewandt angeordnet.

Dient die spezielle Ausbildung der Oberfläche des Kunststofformkörpers hingegen der Erzielung einer möglichst großen effektiven Kontaktfläche des Bauteils bzw. der Baugruppe mit dem Kühlkörper (Wäremdiffusor), so sind die noppen- oder rippenartigen Erhebungen des Kunststofformkörpers der mit ihm verbundenen Oberfläche des Wärmediffusors ab- und dem Bauteil bzw. der Baugruppe zugewandt.

Die Eigenschaften der Anordnung insbesondere unter wechselnden Anpreßdrücken lassen sich dadurch noch verbessern, daß den noppen- oder rippenartigen Erhebungen des Kunststofformkörpers benachbart Ausnehmungen im Kunststofformkörper vorgesehen sind, in die hinein sich bei einer Verformung des Kunststofformkörpers mindestens Teile der Erhebungen erstrecken.

Wenn die Noppen oder Rippen speziell zur angrenzenden Oberfläche (des Kunststofformkörpers oder auch - bei direkter Bildung von einzelnen Noppen bzw. Rippen auf dem Bauteil, der Baugruppe oder dem Kühlkörper - auf dessen bzw. deren Oberfläche) geneigt gebildet werden, legen sie sich beim Andrücken des jeweils anderen Teils zur Seite in die benachbarte Ausnehmung und bilden so eine weitgehend kompakte und in gutem Kontakt zu beiden benachbarten Oberflächen stehende Wärmeübertragungsschicht.

Weitere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
Figur 1 eine Prinzipskizze einer Ausführungsform des erfindungsgemäßen Verfahrens,
Figur 1a eine Detaildarstellung zu Figur 1,
Fign. 2a bis i schematische Teil-Querschnittsdarstellungen von Kunststofformkörpern, die Ergebnis von Ausführungsformen des erfindungsgemäßen Verfahrens sind,
Fig. 3 eine Darstellung eines elektronischen Bauelements mit unmittelbar auf die Oberfläche aufdispensiertem Kunststoff-Kühlkörper als Ergebnis einer weiteren Ausführungsform der Erfindung,
Fig. 4a und b Darstellung weiterer Ausführungsformen des erfindungsgemäßen Verfahrens,
Fig. 5a und 5b Darstellungen einer weiteren Ausführungsform einer mit dem erfindungsgemäßen Verfahren hergestellten Anordnung vor der Montage und im montierten Zustand und
Fig. 6a und 6b Darstellungen einer weiteren Ausführungsform, bei der ein Baugruppenträger und ein zugehöriger Kühlkörper unter Verformung eines dazwischenliegenden Kunststofformkörpers über ein Scharnier miteinander verbunden werden.

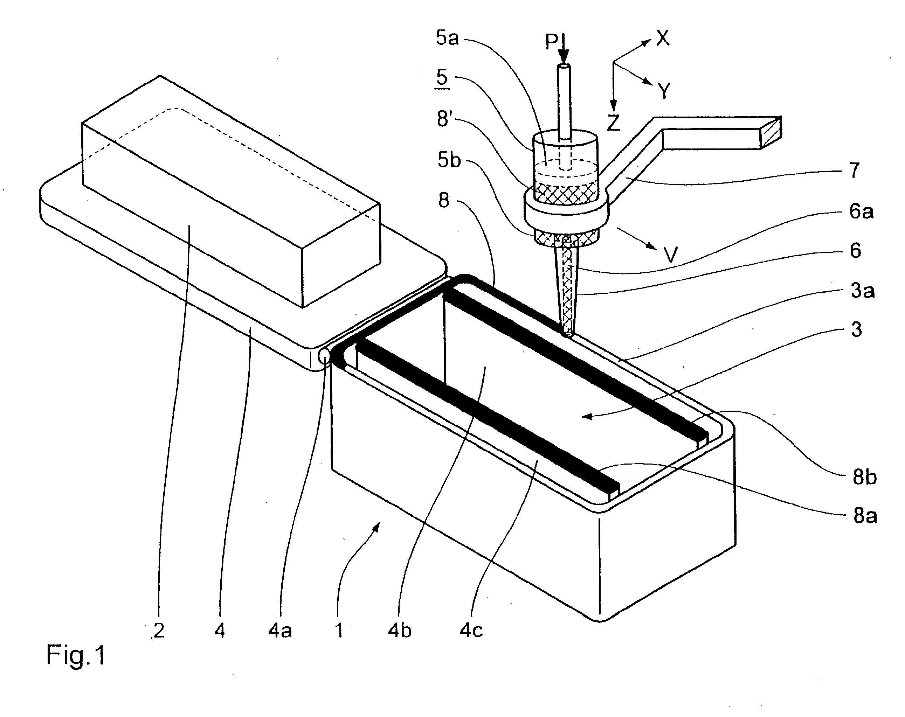

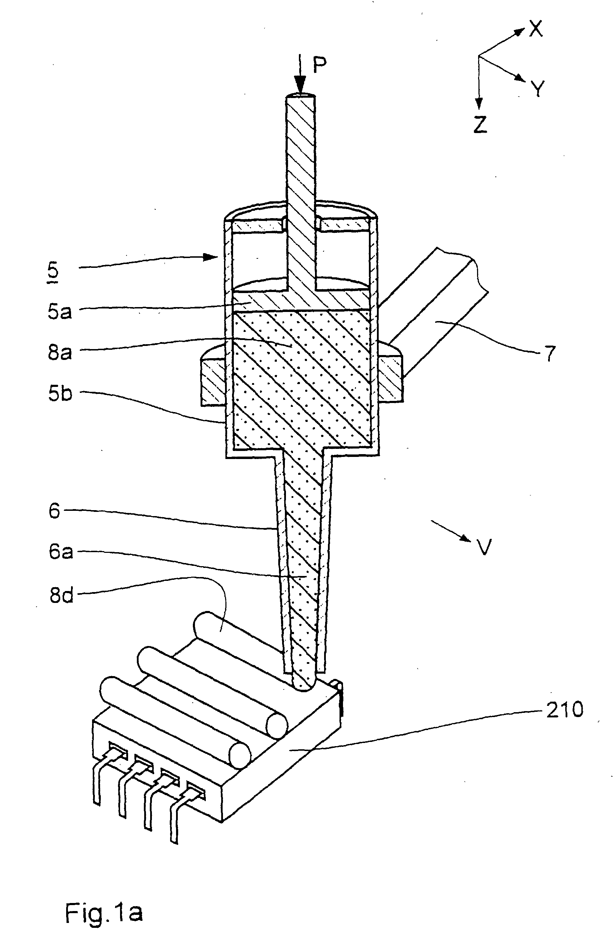

In Fig. 1 ist ein Aluminiumgehäuse 1 als thermischer Diffusor für eine elektronische Schaltungsbaugruppe 2 dargestellt, die elektrisch isoliert auf einem gleichzeitig als Deckel des Gehäuses dienenden Träger 4 befestigt ist. Das Gehäuse 1 soll sowohl zum Schutz als auch zur Kühlung des Schaltungsbaugruppe 2 dienen. Es weist eine Ausnehmung 3 zum Einfügen der Schaltungsbaugruppe auf, der mit dem Träger 4 der Baugruppe nach Umklappen um ein Scharnier 4a verschlossen wird. Im Gehäuse vorgesehene Rippen 4b und 4c, welche im geschlossenen Zustand des Gehäuses den Träger 4 kontaktieren dienen zur verbesserten Wärmeabfuhr.

Weiter ist in Fig. 1 ersichtlich, wie an der Außenwandung des Gehäuseausschnitts 3 über eine luftdicht mit einer Kolben-Zylinder-Vorrichtung 5 verbundene Düse oder Hohlnadel 6, die zusammen mit der Kolben-Zylinder-Vorrichtung 5 durch einen rechnergesteuerten Roboterarm 7 unter Ausübung von Druck p auf den Kolben 5a der Vorrichtung 5 mit geringem und sehr genau eingehaltenem Abstand zum Gehäuse 1 mit der Geschwindigkeit v längs der umlaufenden Kante 3a geführt wird, ein wärme- und elektrisch leitendes Profil 8 durch Dispensieren aufgebracht wird. Das ausgebrachte Profil weist als Außenkontur die Innenkontur der Düse oder Hohlnadel 6 auf. Der Roboterarm ist in den drei Raumrichtungen entsprechend den dargestellten Koordinaten x, y und z angetrieben. Auch auf den oberen Stirnkanten der Rippen 4a und 4b werden entsprechende Profilstränge 8a und 8b aufgebracht.

Der Zylinder 5b der Vorrichtung 5 ist mit einem bei Luftumgebung und Raumtemperatur trocknenden pastösen Silikonpolymeren 8' mit eingelagerten Metallpartikeln gefüllt, das unter dem auf den Kolben 5a ausgeübten Druck durch die Kanüle 6a der Nadel 6 auf die Gehäuseoberfläche aufgedrückt ("dispensiert") wird, dort anhaftet und unter Luftzutritt zu einem elastischen Kunststoffprofil 8 aushärtet.

Die (Querschnitts-)Abmessungen und Gestalt des Kunststoffprofils 8 werden weiterhin durch die physikochemischen Eigenschaften der verwendeten wärmeleitfähigen Kunststoffmasse - insbesondere deren Aushärtungsgeschwindigkeit, Viskosität, Oberflächenspannung bezüglich des Gehäusematerials und Thixotropie -, durch den Querschnitt der Kanüle, den auf den Kolben ausgeübten Druck, die Geschwindigkeit der Nadelbewegung sowie durch Umgebungseinflüsse wie Temperatur und Luftfeuchtigkeit am Herstellungsort bestimmt und sind daher durch geeignete Wahl dieser Parameter ergänzend vorgebbar.

Beim in Fig. 1 gezeigten Gehäuse 1 mit einem einseitig an einem Scharnier angebrachten Klappdekkel 4 kann es vorteilhaft sein, die Auftragnadel 6 längs einem Kantenabschnitt der Öffnung 3 mit höherer Geschwindigkeit als in den anderen Abschnitten zu führen, womit dort in das Schließen des Deckels begünstigender Weise ein Profil mit geringerem Querschnitt als in den übrigen Kantenabschnitten gebildet würde.

Die Einstellung der Eigenschaften der Kunststoffmasse kann dabei insbesondere durch Hinzufügung von Füllstoffen (Ruß o.ä.), Metallbindemitteln, Tensiden und Aushärtungsbeschleunigern bzw. Vernetzungswirkstoffen erfolgen.

Auch die Art und Korngröße der die Wärmeleitfähigkeit sichernden Beimengung - für elektrisch isolierende Kunststofformkörper etwa Bornitrid- oder Aluminiumoxidpartikeln, für auch elektrisch leitfähige Kunststofformkörper etwa Kohlenstoff-, Silber, mit Silber oder Gold ummantelte Kupferpartikeln o.ä. - beeinflußt nicht nur die thermischen, sondern auch die mechanischen, elektrischen und Verarbeitungseigenschaften des wärmeleitfähigen elastischen Materials.

In Figur 1a ist die Vorrichtung zum Aufbringen des leitenden und elastischen Kunststoffmaterials in Strangform noch einmal im Schnitt und vergrößert wiedergeben. Es gelten im übrigen die in Bezug auf Figur 1 verwendeten Bezugszeichen. Als elektronisches Bauelement 210 ist hier ein kunststoffgekapselter integrierter Schaltkreis wiedergegeben, auf dem strangartige thermische Koppelelemente 8d zur Wärmeableitung erzeugt werden.

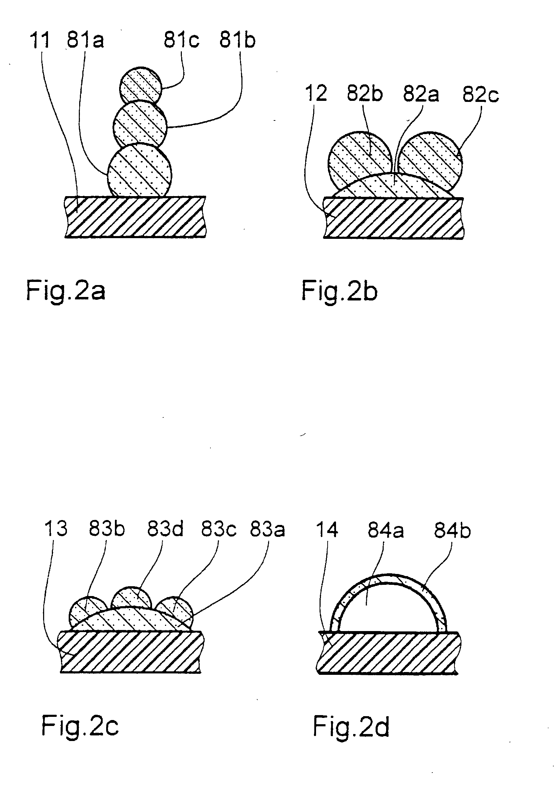

In den Figuren 2a bis k sind Beispiele unterschiedlicher Profilquerschnitte gezeigt, die mittels des erfindungsgemäßen Verfahrens bei Vorsehen mehrerer Auftrags-Schritte hergestellte Anordnungen aufweisen können, bei denen der Kunststofformkörper sich im wesentlichen in eine Richtung erstreckt, d.h. ein Kunstsloffprofil darstellt.

In den Fign. 2a bis 2d sind dabei gut wärmeleitende, weniger elastische Dichtungsteile (schraffiert dargestellt) mit nichtleitenden, aufgrund der fehlenden Beimengung von wärmeleitendem Material elastischeren Dichtungsteilen kombiniert, wodurch eine optimale Verbindung von Dicht- und Wärmeübertragungswirkung erreicht wird.

In den Figuren 2a bis 2i sind Beispiele für die Gestaltung von durch unterschiedliche Düsenformen erzeugbaren strangförmigen wärmeübertragenden Profilkörpern wiedergegeben, welcher zum Teil durch zeitlich sequentielles Auftragen von verschienden Strangprofilen zeitlich nacheinander entstanden sind. Auf diese Weise lassen sich elastische wärmeleitende Körper beliebiger (auch nicht entformbarer) Kontur erzeugen, welche beispielsweise auch Hohlkammern einschließen können.

Fig. 2a zeigt insbesondere einen aus in zwei Auftragsschritten nebeneinander auf der Oberfläche eines Gehäuseteils 11 aufgebrachten Profilen 81 und 82 mit annähernd kreisförmigem Querschnitt gebildeten Wärmeübertragungungs- und Dichtungsaufbau. Ein solcher Aufbau ergibt sich, wenn das elastische Material die Oberfläche des Gehäuses schwach benetzt.

Fig. 2b zeigt einen in drei Schritten erzeugten Profilaufbau aus einem flach gewölbten, breiten leitfähigen Profilteil 82a und einem auf dieses auf"dispensierten" leitfähigen Teil 82c und einem nicht leitfähigen Teil 82b auf einem Gehäuseabschnitt 12, wobei die Teile 82b und 82c annähernd kreisförmigen Querschnitt haben.

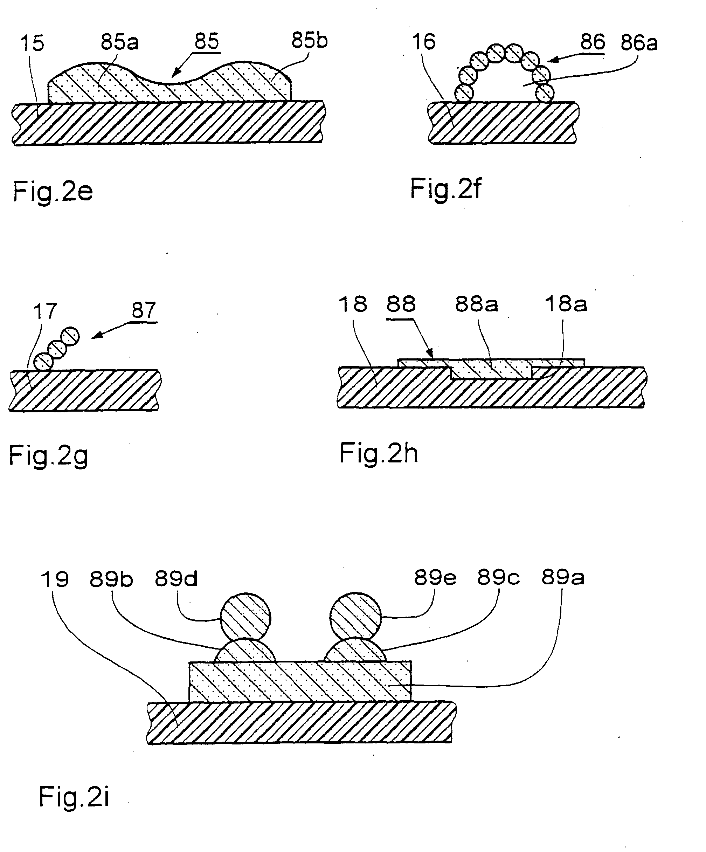

Ein solcher Aufbau ergibt sich, wenn das Material des ersten Profilteils 82a die Oberfläche des Gehäuses stark benetzt und/oder dessen Auftrag mit einer relativ breiten Düse anstelle der in Fig. 2 gezeigten Nadel 6 erfolgte, während das Material der Teile 82b und 82c geringe Benetzungsneigung gegenüber der Oberfläche des Teils 82a zeigt.

Fig. 2c zeigt einen zu Fig. 2b ähnlichen Aufbau, wobei allerdings beidseitig eines auf einem unteren, breiten Profilteil 83a auf einer Gehäuseoberfläche 13 zentral angeordneten hochelastischen, aber nicht leitfähigen, knapp halbkreisförmigen Dichtprofils 83d zwei ebenfalls annähernd halbkreisförmige, hoch wärmeleitfähige Profilteile 83b und 83c angeordnet wurden.

Dieses letztere Profil zeigt große Stabilität gegenüber parallel zur Gehäuseoberfläche wirkenden Kräften, hat jedoch insgesamt eine vergleichsweise geringe Elastizität. Damit kann es etwa für Schiebeverschlüsse besonders geeignet sein.

Das Profil nach Fig. 2d hingegen, das aus einem halbkreisförmig auf eine Gehäuseoberfläche 14 aufgedrückten elastischen, schwach wärmeleitenden Profilteil 84a und einem dessen Oberfläche ummantelnden, gut wärmeleitenden Überzug 84b besteht, weist hingegen ausgeprägt gute Elastizitätseigenschaften bei allerdings verringertem Wärmeleitvermögen auf.

Die Fign. 2e bis 2i zeigen Kunststofformkörper, die ausschließlich aus wärmeleitfähigem Material bestehen.

Fig. 2e zeigt ein speziell geformtes einteiliges Profil 85 auf einer Gehäuseoberfläche 15, das zwei durch eine flachen Steg vebundene Wülste 85a und 85 aufweist. Ein solches Profil kann für Gehäuse mit kantenprofilierten Klappverschlüssen zweckmäßig sein.

Fig. 2f zeigt ein aus mehreren kreisförmigen Profilsträngen insgesamt halbkreisförmig aufgebautes Kunststoffprofil 86 auf einer Gehäuseoberfläche 16, das mit dieser einen Luftraum 86a einschließt.

Das Zusammenwirken des Profils mit dieser "Luftkammer" sorgt für gute Elastizität des Gesamtprofils trotz vergleichsweise schlechter Elastizität seiner Bestandteile.

In Fig. 2h ist ein T-förmiges Profil 88 auf einer eine rechteckige Nut 18a aufweisenden Gehäuseoberfläche 18 dargestellt, das mit einem breiten Mittelteil 88a in die Nut 18a eingreift und insgesamt eine plane, zur Gehäuseoberfläche 18 außerhalb der Nut 18a parallele Oberfläche aufweist.

Dieses Profil ist mit der Gehäuseoberfläche nicht nur stoff-, sondern auch formschlüssig verbunden, was die Stabilität zusätzlich erhöht.

In Fig. 2i ist ein Profilaufbau aus einem annähernd rechteckigen Querschnitt aufweisenden Block 89a aus leitfähigem, elastischem Material und zwei darauf nebeneinander angeordneten, flach gewölbten Profilteilen 89b und 89c gezeigt, der durch seinen großen Querschnitt insbesondere zur Übertragung großer Wärmemengen geeignet ist, aber durch die aufgesetzten Dichtlippen 89b und 89c auch ausreichende Elastizität aufweist.

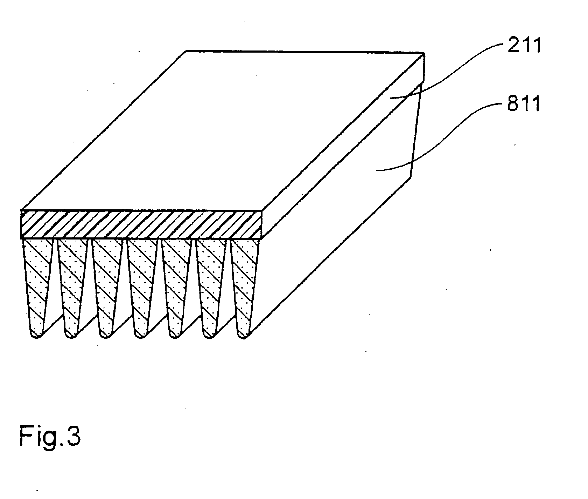

Fig. 3 zeigt schematisch eine elektronische Baugruppe 211 mit auf die in Fig. 1 dargestellte Weise andispensertem Kunststoff-Kühlkörper 811, der aus in jeweils mehreren Strangbildungsschritten schichtweise einzeln auf die Oberfläche der Baugruppe aufgebrachten Kühlrippen besteht. Eine solche Anordnung kann beispielsweise bei elektronischen Geräten im mobilen Einsatz (Funkgeräte, Mobiltelefon o.ä.) Anwendung finden.

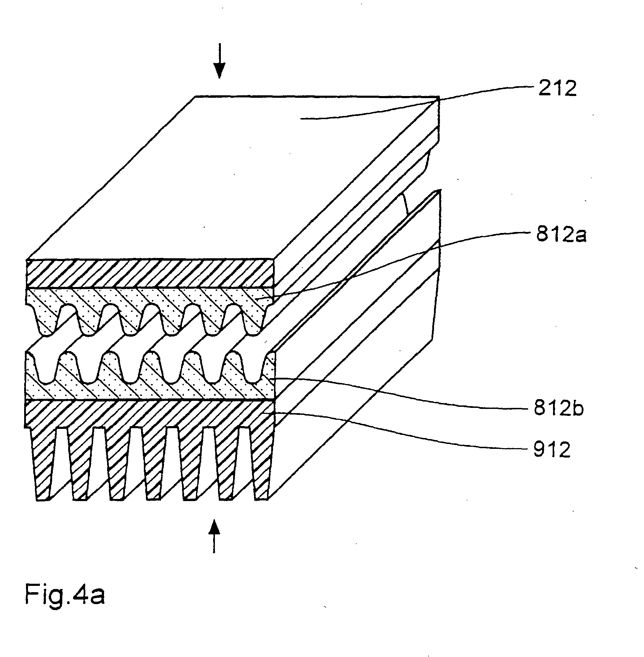

Fig. 4a zeigt schematisch eine elektronische Baugruppe 212 mit angeformtem wärmeleitendem Kunststofformkörper 812a, der eine im Querschnitt wellenförmige Oberfläche aufweist und mit einem verrippten Kühlkörper 912 als Wärmediffusor verbunden wird, an dessen ebene Oberfläche ein zweiter Kunststofformkörper 812b angeformt ist. Dessen Oberfläche weist die gleiche Struktur wie die des ersten Kunststofformkörpers 812a auf, er ist jedoch diesem gegenüber seitlich etwas versetzt aufgebracht, so daß die Erhebungen auf dem einen Körper jeweils in Vertiefungen des anderen eingreifen und vermöge ihrer Elastizität beide Körper beim Zusammenpressen von Baugruppe 212 und Kühlkörper 912 eine nahezu homogene Wäremeübertragungsschicht bilden.

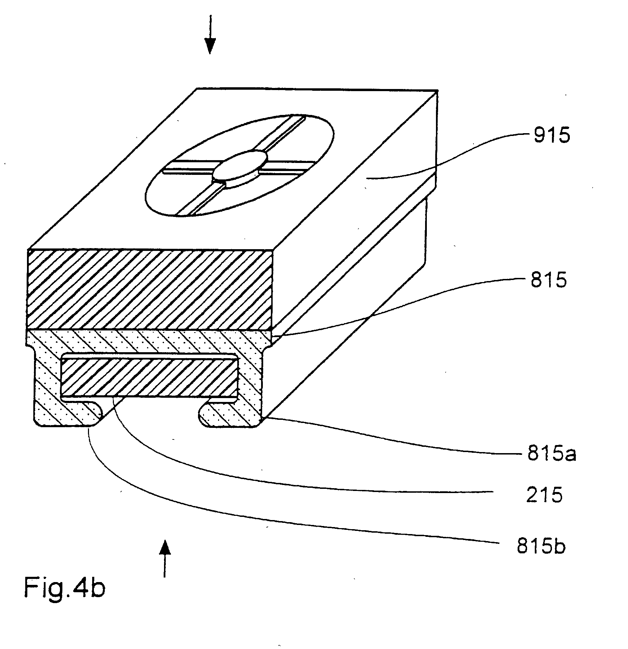

In Figur 4b ist in einer Schnittdarstellung wiedergegeben, wie ein elektronisches Bauelement 215 in einen auf einem aktiven Lüfterlement 915 als Wärmediffusor wirkenden Körper, der mit einer elastischen wärmeleitenden Struktur 815 versehen ist, dadurch "einknöpfbar" ist, daß die Quererstreckung der Struktur in zunehmendem Abstand von ihrer Unterlage ebenfalls zunimmt. Das in der Figur wiedergegebene Schnittbild entspricht dabei auch einer Vertikalschnittdarstellung in einer dazu senkrechten Richtung, so daß ein Kragenbereich 815a das eingefügte Bauelement 215 auf einer ringförmig geschlossenen Linie gegen Herausfallen sichert.

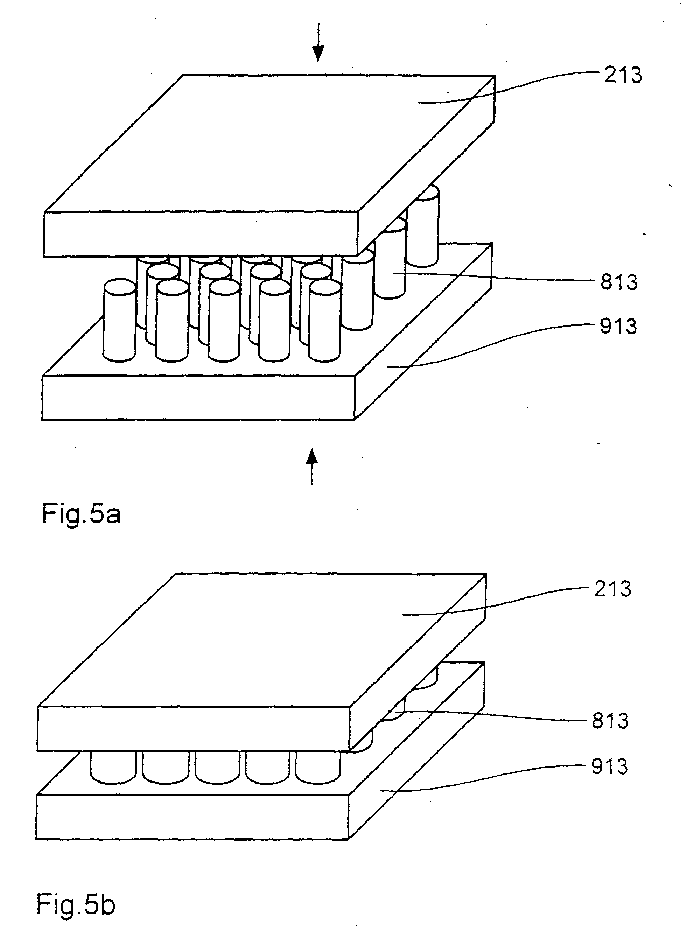

Ein ähnlicher Endzustand wird mit der schematisch in Fign. 5a und 5b gezeigten Anordnung erreicht, bei der eine Baugruppe 213 über ein Array 813 aus einzelnen, hochelastischen Kunststoffnoppen, das auf einen Kühlkörper 913 aufgebracht ist, mit diesem verbunden wird. Durch das Zusammenpressen von Baugruppe 213 und Kühlkörper 913 werden die Noppen bzw. Inseln des Arrays 813 in der Höhe komprimiert, womit sich ihr Querschnitt vergrößert und sie im wesentlichen den Zwischnenraum zwischen der Baugruppe und dem Kühlkörper ausfüllen und für gute Wäremübertragung sorgen.

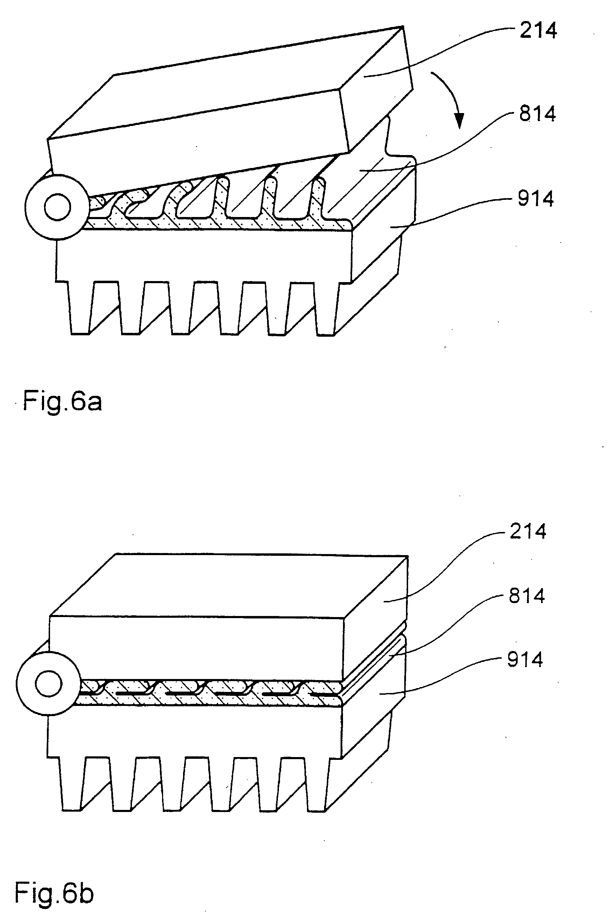

Fig. 6a und 6b zeigen eine weitere Ausführungsform, bei der eine Baugruppe 214 und ein verrippter Kühlkörper 914 über ein Scharnier 914a miteinander verbunden werden, wobei der Kühlkörper auf seiner nicht verrippten Oberfläche einen Kunststofformkörper 814 mit geneigt angeordneten Rippen trägt. Beim Zusammenklappen von Baugruppe 214 und Kühlkörper 914 legen sich - wie Fig. 6a für die erste Rippe von links verdeutlicht und Fig. 6b im Endzustand zeigt - die Rippen des Kunststofformkörpers 814 unidirektional in den jeweils benachbarten Zwischenraum. Auf diese Weise entsteht ein weitgehend homogener, mit den angrenzenden Oberflächen in engem Kontakt stehender Wärmeübertragungskörper zwischen Baugruppe und Kühlkörper.

Die Erfindung beschränkt sich in ihrer Ausführung nicht auf die vorstehend angegebenen Ausführungsbeispiele. Vielmehr ist eine Anzahl von Varianten denkbar. Dazu zählen insbesondere Anordnungen zur Wärmeübertragung auch außerhalb des Gebiets der Elektronik, etwa in der Meß-, Heiz-, Kühl- und Klimatechnik.

## Patentansprüche

1. Verfahren zur Herstellung einer Anordnung zur Ableitung von Wärme vom Gehäuse eines elektronischen, Verlustwärme erzeugenden, mit einem unmittelbar auf der Oberfläche eines mit dem Gehäuse des Schaltungsbauteils oder einer entsprechenden Baugruppe wärmeleitend verbundenen zusätzlichen Wärmediffusors angeordneten, getrennt gebildeten Formkörper zwischen Gehäuse des Schaltungsbauteils oder einer entsprechenden Baugruppe and Wärmediffusor (811; 812a) aus wärmeleitendem Kunststoff, den Wärmediffusor (1, 1'; 11 bis 14; 912 bis 914) flächig kontaktiert und mindestens bereichsweise elastisch verformbar oder kompressibel ist,
**dadurch gekennzeichnet,**
**daß** Kunststoffmaterial (8') in plastischem Zustand unter Druck aus einem Vorratsbehälter durch eine Hohlnadel (6) bzw. Düse in Form eines Strangs mit einer Querschnittsform, die dem Innenquerschnitt der Düse oder Hohlnadel im wesentlichen entsprucht, unmittelbar auf einen Bereich (3a) des Wärmediffusors, auf dem der Formkörper (8) gebildet werden soll, durch Dispensieren aufgebracht und nach dem Aufbringen unter Beibehaltung der Querschnittsform zu einem entsprechenden elastischen Körper gehärtet bzw. vernetzt wird.

2. Verfahren zur Herstellung einer Anordnung zur Ableitung von Wärme vom Gehäuse eines elektronischen, Verlustwärme erzeugenden, mit einem auf der Oberfläche des Gehäuses des Schaltungsbauteils oder einer entsprechenden Baugruppe (2, 211 bis 214) angeordneten, getrennt gebildeten Formkörper (811; 812a) aus wärmeleitendem Kunststoff, der das Gehäuse des Schaltungsbauteils oder einer entsprechenden Baugruppe flächig kontaktiert und mindestens bereichsweise elastisch verformbar oder kompressibel ist,
**dadurch gekennzeichnet,**
**daß** Kunststoffmaterial (8') in plastischem Zustand unter Druck aus einem Vorratsbehälter durch eine Hohlnadel (6) bzw. Düse in Form eines Strangs mit einer Querschnittsform, die dem Innenquerschnitt der Düse oder Hohlnadel im wesentlichen entsprucht, unmittelbar auf einen Bereich (3a) des Gehäuses des Schaltungsbauteils oder einer entsprechenden Baugruppe, auf dem der Formkörper (8) gebildet werden soll, durch Dispensieren aufgebracht und nach dem Aufbringen unter Beibehaltung der Querschnittsform zu einem entsprechenden elastischen Körper gehärtet bzw. vernetzt wird.

3. Verfahren nach Anspruch 1 oder 2, **dadurch gekennzeichnet, daß** die Hohlnadel (6) bzw. Düse durch Antriebsmittel, insbesondere rechnergesteuert, auf einem vorgegebenen Weg über den Bereich (3a) des Teils (1), an dem der Formkörper (8) erzeugt werden soll, geführt wird.

4. Verfahren nach Anspruch 1, 2 oder 3 **dadurch gekennzeichnet, daß** zur Herstellung eines mehrschichtigen Formkörpers (8) die Nadel (6) bzw. Düse mindestens über vorbestimmte Abschnitte des Bereiches (3a), an dem der Formkörper erzeugt werden soll, mehrfach derart geführt wird, daß sich aus mehreren Strängen des Kunststoffmaterials (8') eine vorgegebene Gestalt des Formkörpers aufbaut, wobei ein nachfolgender Strang vor dem Aushärten bzw. Vernetzen der Oberfläche des vorangehenden Strangs aufgebracht wird, so daß beide Stränge sich nach dem Aushärten oder Vernetzen materialkonform verbinden.

5. Verfahren nach Anspruch 4, **dadurch gekennzeichnet, daß** beim mehrfachen Führen der Nadel (6) bzw. Düse über die vorbestimmten Bereiche unterschiedlich elastisch oder unterschiedlich kompressibel aushärtende Kunststoffmaterialien aufgebracht werden.

6. Verfahren nach einem der Ansprüche 1 bis 5, **dadurch gekennzeichnet, daß** das Aufbringen des plastischen Kunststoffmaterials bei Raumtemperatur erfolgt.

## Claims

1. Process for the production of an arrangement to dissipate heat from the housing of a heat-loss generating electronic circuit component, or a corresponding subassembly with a separately formed moulding (811; 812a) of heat-conducting synthetic material which is arranged directly on the surface of an additional heat diffuser, connected to the housing of the circuit component or of a corresponding subassembly in a manner so as to conduct heat, is located between the housing of the circuit component or of a corresponding subassembly and the heat diffuser, contacts the heat diffuser (1, 1'; 11 to 14; 912 to 914) in a laminar fashion and can be elastically moulded or compressed at least in some areas, **characterized in that** synthetic material (8') in a plastic state is to be dispensed under pressure, from a storage container via a hollow needle (6), or a jet, in the form of a strand with a cross-sectional shape which corresponds substantially to the interior cross-section of the jet or hollow needle, directly on one area (3a) of the heat diffuser onto which the moulding (8) is to be formed, and after application is to be hardened or crosslinked into a corresponding elastic body whilst maintaining its cross-sectional shape.

2. Process for the production of an arrangement to dissipate heat from the housing of a heat-loss generating electronic circuit component, or a corresponding subassembly with a separately formed moulding of heat-conducting synthetic material which is arranged on the surface of the housing (2, 211 to 214) of the circuit component or of a corresponding subassembly, contacts the housing of the circuit component or of a corresponding subassembly in a laminar fashion and can be elastically moulded or compressed at least in some areas, **characterized in that** synthetic material (8') in a plastic state is to be dispensed under pressure, from a storage container via a hollow needle (6), or a jet, in the form of a strand with a cross-sectional shape which corresponds substantially to the interior cross-section of the jet or hollow needle, directly on one area (3a) of the housing of the circuit component or of a corresponding subassembly on which the moulding (8) is to be formed, and after application is to be hardened or crosslinked into a corresponding elastic body whilst maintaining its cross-sectional shape.

3. Process according to Claim 1 or 2, **characterized in that** the hollow needle (6) or jet is guided by driving means, especially computer-controlled, along a predetermined path over the area (3a) of the part (1) on which the moulding (8) is to be formed.

4. Process according to Claim 1, 2 or 3, **characterized in that** in order to produce a multi-layer moulding (8), the needle (6) or jet is moved at least over predetermined sections of the area (3a) on which the moulding is to be formed several times in such a way that a specified shape of the moulding is formed from a plurality of strands of the synthetic material (8'), wherein a subsequent strand is applied before hardening or crosslinking the surface of the preceding strand so that both strands join together in a material-conforming fashion after hardening or crosslinking.

5. Process according to Claim 4, **characterized in that** on repeated guiding of the needle (6) or jet over the predetermined areas, synthetic materials which harden in a differently-elastic or differently-compressible manner are applied.

6. Process according to any of Claims 1 to 5, **characterized in that** the plastic synthetic material is applied at room temperature.

## Revendications

1. Procédé de fabrication d'un dispositif pour l'évacuation de la chaleur du boîtier d'un composant électronique, comportant un élément préformé (811 ; 812a) disposé directement sur la surface d'un diffuseur de chaleur supplémentaire relié en conduction thermique avec le boîtier du composant de commutation ou d'un composant correspondant et formé séparément, entre le boîtier du composant de commutation et le diffuseur de chaleur ou d'un composant correspondant et le diffuseur de chaleur en matériau plastique thermoconducteur, qui vient en contact, à plat, avec le diffuseur de chaleur (1, 1' ; 11 à 14 ; 912 à 914) et qui est, au moins par secteurs, déformable par élasticité ou compressible, **caractérisé en ce que** du matériau plastique (8') est, à partir d'un réservoir, au moyen d'une aiguille creuse (6) ou d'une buse, appliqué à l'état plastique, sous pression et en forme de cordon dont la section correspond sensiblement à la section intérieure de la buse ou de l'aiguille creuse, directement sur une zone (3a) du diffuseur de chaleur sur laquelle doit être constitué l'élément préformé (8) et est, après l'application et en gardant la forme de section, durci ou réticulé pour former un corps élastique correspondant.

2. Procédé de fabrication d'un dispositif pour l'évacuation de la chaleur du boîtier d'un composant électronique, comportant un élément préformé (811 ; 812a) en matériau plastique thermoconducteur disposé sur la surface du boîtier du composant de commutation ou d'un composant correspondant (2, 211 à 214) et formé séparément, qui assure un contact en surface avec le boîtier du composant de commutation ou d'un composant correspondant et qui est, au moins par secteurs, déformable par élasticité ou compressible, **caractérisé en ce que** du matériau plastique (8') est, à partir d'un réservoir, au moyen d'une aiguille creuse (6) ou d'une buse, appliqué à l'état plastique, sous pression et en forme de cordon dont la section correspond sensiblement à la section intérieure de la buse ou de l'aiguille creuse, directement sur une zone (3a) du boîtier du composant de commutation ou d'un composant correspondant sur laquelle doit être constitué l'élément préformé (8) et est, après l'application et en gardant la forme de section, durci ou réticulé pour former un corps élastique correspondant.

3. Procédé selon la revendication 1 ou 2, **caractérisé en ce que** l'aiguille creuse (6) ou la buse est guidée par un moyen d'entraînement, en particulier sous commande d'un ordinateur, selon un trajet imposé sur la zone (3a) de la partie (1) sur laquelle doit être produit l'élément préformé (8).

4. Procédé selon la revendication 1, 2 ou 3, **caractérisé en ce que**, pour la réalisation d'un élément préformé multicouches (8), l'aiguille (6) ou la buse est guidée plusieurs fois, au moins sur des sections prédéterminées de la zone (3a) sur laquelle doit être constitué l'élément préformé (8), de telle façon qu'avec plusieurs cordons du matériau plastique (8') se constitue une structure prescrite de l'élément préformé, procédé dans lequel un cordon suivant est appliqué avant le durcissement ou la réticulation de la surface du cordon précédent, de sorte qu'après le durcissement ou la réticulation les deux cordons soient unis en conformité avec la structure du matériau.

5. Procédé selon la revendication 4, **caractérisé en ce que**, lors du guidage multiple de l'aiguille (6) ou de la buse sur les zones prédéterminée, sont appliqués des matériaux plastiques qui durcissent avec une élasticité différente ou une compressibilité différente.

6. Procédé selon l'une quelconque des revendications 1 à 5, **caractérisé en ce que** l'application du matériau plastique plastique a lieu à la température ambiante.
